(19) Europäisches Patentamt / European Patent Office / Office européen des brevets

(11) **EP 3 012 874 B1**

(12) **EUROPÄISCHE PATENTSCHRIFT**

(45) Veröffentlichungstag und Bekanntmachung des Hinweises auf die Patenterteilung:
**20.12.2023   Patentblatt 2023/51**

(21) Anmeldenummer: **14003616.1**

(22) Anmeldetag: **23.10.2014**

(51) Internationale Patentklassifikation (IPC):
*H01L 31/041* (2014.01)    *H01L 31/0687* (2012.01)
*H01L 31/0304* (2006.01)    *H01L 31/18* (2006.01)

(52) Gemeinsame Patentklassifikation (CPC):
**H01L 31/0687; H01L 31/03046; H01L 31/041; H01L 31/1844;** Y02E 10/52; Y02E 10/544; Y02P 70/50

(54) **Stapelförmige integrierte Mehrfachsolarzelle**

Integrated stacked multiple solar cell

Cellule solaire à jonctions multiples intégrée en forme de pile

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**27.04.2016   Patentblatt 2016/17**

(73) Patentinhaber: **AZUR SPACE Solar Power GmbH 74072 Heilbronn (DE)**

(72) Erfinder:
• **Guter, Wolfgang**
  **70190 Stuttgart (DE)**
• **Strobl, Gerhard**
  **70439 Stuttgart (DE)**
• **Dimroth, Frank**
  **79115 Freiburg (DE)**
• **Walker, Alexandre William**
  **Ottawa, Ontario**
  **K1T 3Z7 (CA)**

(74) Vertreter: **Koch Müller Patentanwaltsgesellschaft mbH Maaßstraße 32/1 69123 Heidelberg (DE)**

(56) Entgegenhaltungen:
DE-A1-102012 004 734    US-A1- 2006 185 582
US-A1- 2009 229 659    US-A1- 2012 138 116

• BISSELS ET AL: "Optimum Bandgap Calculations for a 4-Terminal Double Tandem III-V Concentrator Solar Cell Structure", PROCEEDINGS OF THE 22ND PHOTOVOLTAIC SOLAR ENERGY CONFERENCE, 3. September 2007 (2007-09-03), - 7. September 2007 (2007-09-07), XP040513093, Milan-ITALY ISBN: 978-3-936338-22-5
• SHARPS P R ET AL: "Development of 20% efficient GaInAsP solar cells", PROCEEDINGS OF THE PHOTOVOLTAIC SPECIALISTS CONFERENCE. LOUISVILLE, MAY 10 - 14, 19; [PROCEEDINGS OF THE PHOTOVOLTAIC SPECIALISTS CONFERENCE], NEW YORK, IEEE, US, vol. CONF. 23, 10 May 1993 (1993-05-10), pages 633-638, XP010113181, DOI: 10.1109/PVSC.1993.347019 ISBN: 978-0-7803-1220-3

**Beschreibung**

Die Erfindung betrifft eine stapelförmige integrierte Mehrfachsolarzelle.

Um mit Solarzellen möglichst hohe Effizienzen für die Umwandlung von Sonnenlicht in elektrische Energie zu erreichen, werden seit einigen Jahren Mehrfachsolarzellen aus unterschiedlichen Halbleitermaterialien untersucht [W. Guter, Optimierung von III-V basierten Hochleistungssolarzellen, Dissertation, Uni Konstanz, Fakultät für Physik, 2011]. Mehrfachsolarzellen teilen das einfallende Licht auf mehrere übereinander gestapelte Teilsolarzellen mit unterschiedlicher Bandlückenenergie auf. Um höchste Effizienzen zu erreichen, müssen die Halbleitermaterialien und deren Bandlückenenergie an einander angepasst werden, so dass vorzugsweise jede der elektrisch in Serie verschalteten Teilsolarzellen möglichst den gleichen Strom generiert. Des Weiteren ist für Weltraumanwendungen neben hohen Wirkungsgraden auch eine hohe Strahlungsstabilität gegenüber hochenergetischen Elektronen und/oder Protonen (z.B. Sonneneruption) wünschenswert.

Sofern die Halbleitermaterialien der einzelnen Teilzellen des Stapels die gleiche Gitterkonstante aufweisen, lassen sich die Teilzellen mittels eines epitaktischen Verfahrens herstellen. Aus Meusel et al., III-V MULTIJUNCTION SOLAR CELLS - FROM CURRENT SPACE AND TERRESTRIAL PRODUCTS TO MODERN CELL ARCHITECTURES, 5th WCPEC, 2010, Valencia, 1AP.1.5 ist eine gitterangepasste 4-fach Solarzelle aus AlInGaP, InGaAs, InGaNAs und Ge bekannt. Aus Gründen der Kristallqualität insbesondere von der InGaNAs Teilzelle werden nur unzureichende Wirkungsgrade erreicht.

Weisen die Teilzellen unterschiedliche Gitterkonstanten auf, werden in einer ersten Alternative zwischen zwei Teilzellen metamorphe Pufferschichten eingesetzt. Aus Guter et al., DEVELOPMENT, QUALIFICATION AND PRODUCTION OF SPACE SOLAR CELLS WITH 30% EOL EFFICIENCY, European Space Power Conference, 2014, Noordwijkerhout, The Netherlands ist eine Abfolge von Teilzellen aus AlInGaP, AlInGaAs, InGaAs, einem metamorphen Puffer und Ge bekannt. Ferner ist aus Cornfeld et al., Development of a four sub-cell inverted metamorphic multi-junction (IMM) highly efficient AM0 solar cell, 35th IEEE PVSC, 2010, Honolulu, USA eine weitere Abfolge von Teilzellen aus InGaP, GaAs mit einem ersten metamorphen Puffer, einer ersten InGaAs Teilzelle und einem zweiten metamorphen Puffer und einer zweiten InGaAs Teilzelle bekannt.

Eine weitere Alternative, Materialien mit unterschiedlicher Gitterkonstante zu kombinieren ist die Verwendung von Waferbonding-Verfahren. Hierbei werden Teilzellen mit unterschiedlichen Gitterkonstanten gefügt. Aus der Dissertation Uwe Seidel, Grenzflächenuntersuchungen am Tunnelkontakt einer MOCVD-präparierten Tandemsolarzelle, HU Berlin, Mathematisch-Naturwissenschaftlichen Fakultät I, 09.01.2007 und aus J. Bois-vert et al., Development of advanced space solar cells at spectrolab, in: Photovoltaic Specialists Conference (PVSC), 2010 35th IEEE, 20-25 June 2010, Honolulu, ISSN: 0160-8371 und aus R. Krause et al., Wafer Bonded 4-Junction GaInP/GaAs//GaInAsP/GaInAs, AIP Conference Proceedings 1616, 45 (2014); doi: 10.1063/1.4897025 sind gebondete Solarzellstapel mit vier Teilzellen bekannt. Ferner ist aus P.T. Chiu et al., Direct Semiconductor Bonded 5J Cell For Space And Terrestrial Applications, IEEE Journal of Photovoltaics, Volume 4(1), pp. 493, 2014 ein 5-fach Solarzellenstapel mit zwei gebondeten Solarzellenteilen bekannt. Weitere Mehrfachsolarzellen sind aus der US 2012 / 0138116 A1, der US 2009 / 0229659 A1, der US 2006 / 0185582 A1, der DE 10 2012 004 734 A1, aus "Development of 20% efficient GaInAsP solar cells", T. Sharps et al., Proceedings of the Photovoltaic Specialists Conference, 1993, pp. 633-638, XP010113181, DOI: 10.1109/PVSC.1993.347019, ISBN:

978-0-7803-1220-3 und aus Bissels et al: "Optimum Bandgap Calculations
for a 4-Terminal Double Tandem III-V Concentrator Solar Cell Structure",
Proceedings of the 22nd photovoltaic solar energy conference, 3. September 2007, Milan-Italy, ISBN: 978-3-936 338-22-5 bekannt.

Vor diesem Hintergrund besteht die Aufgabe der Erfindung darin, eine Vorrichtung anzugeben, die den Stand der Technik weiterbildet und eine strahlungsharte Weltraumsolarzelle mit hohem Wirkungsgrad bereitzustellen.

Die Aufgabe wird durch eine stapelförmige integrierte Mehrfachsolarzelle mit den Merkmalen des Patentanspruchs 1 gelöst. Vorteilhafte Ausgestaltungen der Erfindung sind Gegenstand von Unteransprüchen.

Gemäß dem Gegenstand der Erfindung wird eine stapelförmige integrierte Mehrfachsolarzelle mit einer ersten Teilzelle bereitgestellt, wobei die erste Teilzelle eine Schicht aus AlInGaP mit einer ersten Gitterkonstante und einer ersten Bandlückenenergie aufweist und die Dicke der Schicht größer als 100 nm ist und die Schicht als Teil des Emitters und / oder als Teil der Basis und / oder als Teil der zwischen Emitter und Basis liegenden Raumladungszone ausgebildet ist, und einer zweiten Teilzelle, wobei die zweite Teilzelle eine Schicht mit einer zweiten Gitterkonstante und einer zweiten Bandlückenenergie aufweist, wobei die Schicht der zweiten Teilzelle aus InP oder aus InGaAsP besteht und die Dicke der Schicht größer als 100 nm ist und die Schicht als Teil des Emitters und / oder als Teil der Basis und / oder als Teil der zwischen Emitter und Basis liegenden Raumladungszone ausgebildet ist, und einer dritten Teilzelle, wobei die dritte Teilzelle eine Schicht aus $In_xGa_{1-x}As_{1-y}P_y$ mit einer dritten Gitterkonstanten und einer dritten Bandlückenenergie aufweist, und die Dicke der Schicht größer als 100 nm ist und die Schicht als Teil des Emitters und / oder als Teil der Basis und / oder als Teil der zwischen Emitter und Basis liegenden Raumladungszone ausgebildet ist, und einer vierten Teilzelle, wobei die vierte Teilzelle eine Schicht aus InGaAs mit einer vierten Gitterkonstanten und einer vierten Bandlückenenergie aufweist, und die Dicke der Schicht größer als 100 nm ist und die Schicht als Teil des Emitters und / oder als Teil der Basis und / oder als Teil der zwischen Emitter und Basis liegenden Raumladungszone ausgebildet ist, wobei für die Bandlückenenergien gilt Eg1 > Eg2 > Eg3 > Eg4, und zwischen zwei Teilzellen ein Bereich mit einem Wafer Bond ausgebildet ist, und der Bereich eine Dicke von maximal 200 nm aufweist, und die Gitterkonstante in dem Bereich einen Sprung von mindestens 0,01 nm macht, und die Schicht der dritten Teilzelle und die Schicht der vierten Teilzelle zueinander gitterangepasst sind und für die Gitterkonstanten gilt a3 = a4 ± Δ1 mit, Δ1 ≤ 0,003 nm, und für die Stöchiometrie der Schicht der dritten Teilzelle gilt 1 > x > 0,2 und 1 > y > 0,1.

Aus Gründen der Klarheit sei angemerkt, dass die Beziehung Eg1 > Eg2 > Eg3 > Eg4 bedeutet, dass die erste Teilzelle eine größere Bandlückenenergie als die zweite Teilzelle und die zweite Teilzelle eine größere Bandlückenenergie als die dritte Teilzelle und die dritte Teilzelle eine größere Bandlückenenergie als die vierte Teilzelle aufweist.

Es versteht sich, dass die Teilzelle mit der größten Bandlückenenergie oben auf der stapelförmigen integrierten Mehrfachsolarzelle angeordnet ist, d.h. das Sonnenlicht trifft auf die Oberfläche der ersten Teilzelle auf. Nach dem Durchlaufen der ersten Teilzelle trifft das nicht absorbierte Licht auf die zweite Teilzelle bis schließlich in der vierten und untersten Teilzelle der langwellige Bereich des Lichtes absorbiert wird. Sofern ein Trägersubstrat für die stapelförmige integrierte Mehrfachsolarzelle vorhanden ist, ist das Trägersubstrat immer mit der untersten Teilzelle verbunden. Es sei angemerkt, dass bis auf den Bereich mit dem Wafer Bond die Teilzellen unterhalb des Wafer Bonds und oberhalb des Wafer Bonds jeweils monolithisch integriert sind. Des Weiteren sei angemerkt, dass nachfolgend der Begriff "Solarzellenstapel" synonym für die Bezeichnung "stapelförmige integrierte Mehrfachsolarzelle" verwendet wird und dass unter dem Begriff "Wafer Bond" ein Fügen von zwei Halbleiterscheiben verstanden wird.

Ein Vorteil ist es, dass der erfindungsgemäße Solarzellenstapel einen hohen Wirkungsgrad und eine Vielzahl von strahlungsharten Teilzellen aufweist. Hierbei werden mehr als eine Teilzelle mit einer InP Verbindung verwendet. Insbesondere werden besonders strahlungsstabile Materialien, wie AlInGaP und InP, sowie InGaAsP eingesetzt. Untersuchungen haben gezeigt, dass insbesondere bei InP bereits bei Temperaturen unter 300 K eine Ausheilung von Strahlungsschäden eintritt, während bei GaAs basierten Teilzellen eine Ausheilung erst ab Temperaturen oberhalb 600 K einsetzt. Anders ausgedrückt, lässt sich durch das Zusammenfügen von strahlungsharten Teilzellen mit gleichzeitig aufeinander abgestimmten Bandlücken ein Solarzellenstapel mit hohem Wirkungsgrad herstellen, wobei sich der Solarzellenstapel aufgrund der besonderen Strahlungshärte auch bevorzugt für Weltraumanwendungen eignet.

Erfindungsgemäß ist ein Substrat aus einer Verbindung aus InP und GaAs, ausgebildet. Die Substrate werden als Träger bei der Herstellung der beiden Solarzellenteile verwendet. Vorliegend werden zwei Substrate mit zueinander unterschiedlichen Gitterkonstanten verwendet. Erfindungsgemäß werden auf jedem der Substrate mittels eines Epitaxieverfahrens ein oder mehrere Teilzellen hergestellt. Nach dem Bonden der Teilzellen wird wenigstens das Substrat auf der ersten Tellsolarzelle abgelöst.

In einer Weiterbildung ist die Dicke der Schicht der vierten Teilzelle kleiner als 2,2 μm und/oder ein Halbleiterspiegel unter der vierten Teilsolarzelle ausgebildet. Je geringer die Dicke der Schicht desto größer ist die Strahlungsstabilität der Teilzelle. Ferner lässt sich unter der vierten Teilzelle auch eine Halbleiterspiegel anordnen, um die Schichtdicke der Teilzelle zu verringern. Es versteht sich, dass mit dem Einbau des Halbleiterspiegels unter der vierten Teilzelle ein bestimmter Wellenlängenbereich durch Reflektion in den Absorptionsbereich der darüber liegenden Teilzelle gespiegelt wird. Der optische Weg durch den Absorptionsbereich wird hierdurch in erster Näherung verdoppelt. In einer alternativen Ausführungsform ist unter der vierten Teilzelle ein optischer Rückseitenspiegel vorgesehen, wobei der Rückseitenspiegel eine Metallverbindung oder eine Kombination aus einer Metallverbindung und einer dielektrischen Schicht umfasst. Hierdurch wird auf einfache Weise erreicht, dass das Licht breitbandig wieder in die Zelle zurückreflektiert wird.

Nachfolgend werden die Begriffe Rückseitenspiegel und optischer Spiegel synonym verwendet. Eine genaue Einstellung des Halbleiterspiegels auf den Wellenlängenbereich entfällt mit dem optischen Spiegel. Ferner ist ein optischer Spiegel kostengünstig und einfach herzustellen und weist wesentlich höhere Reflektionsgrade als ein Halbleiterspiegel, nämlich nahe 100% auf. Durch die Reflektion des nicht von der Mehrfachsolarzelle genutzten infraroten Lichts wird außerdem im Weltall die Betriebstemperatur der Solarzelle signifikant reduziert und dadurch der Wirkungsgrad der Mehrfachsolarzelle weiter erhöht.

In einer bevorzugten Ausführungsform ist der Halbleiterspiegel zwischen der dritten und vierten Teilzelle ausgebildet. Der Halbleiterspiegel reflektiert bevorzugt den Wellenlängenbereich des Lichts, das in der dritten Teilzelle absorbiert werden kann. Durch den Halbleiterspiegel wird der optische Weg des Lichtes durch die dritte Teilzelle verlängert. Gleichzeitig wird bevorzugt längerwelliges Licht für die Absorption in der vierten Teilzelle transmittiert.

In einer besonders bevorzugten Ausführungsform ist zusätzlich zu dem Halbleiterspiegel zwischen der dritten Teilzelle und der vierten Teilzelle der optische Spiegel unterhalb der vierten Teilzelle ausgebildet.

In einer anderen Ausführungsform weist der Bereich in dem der Sprung ausgebildet ist, eine Dicke von maximal 100 nm auf und/oder die Gitterkonstante macht einen Sprung von mindestens 0,015 nm. Es versteht sich, dass unter der Bezeichnung "Bereich" ein Gebiet bezeichnet wird, das die Grenzfläche des Wafer Bonds umfasst, wobei die Ausdehnung oder die Dicke des Grenzflächengebietes in den meisten Fällen nur wenige nm beträgt. In einer bevorzugten Ausführungsform ist der Wafer Bond und hierdurch der Sprung der Gitterkonstanten zwischen der ersten Teilzelle und der zweiten Teilzelle ausgebildet.

In einer bevorzugten Weiterbildung sind die Schicht der dritten Teilzelle und die Schicht der vierten Teilzelle zueinander gitterangepasst und/oder es gilt für die Gitterkonstanten a3 = a4 $\pm$ $\Delta$2, mit $\Delta$2 $\leq$ 0,0015 nm.

In einer nicht beanspruchten Weiterbildung besteht die Schicht der vierten Teilzelle aus einer InGaAsP Verbindung, wobei der Phosphorgehalt in Bezug auf die Elemente der Gruppe V größer als 5% und/oder kleiner als 30% ist.

Erfindungsgemäß ist zwischen der ersten Teilzelle und dem Wafer Bond eine fünfte Teilzelle ausgebildet, wobei die fünfte Teilzelle eine Schicht mit einer fünften Gitterkonstanten und einer fünften Bandlückenenergie aufweist, und die Dicke der Schicht größer als 100 nm ist und die Schicht als Teil des Emitters und / oder als Teil der Basis und / oder als Teil der zwischen Emitter und Basis liegenden Raumladungszone ausgebildet ist, und wobei für die Bandlückenenergie gilt Eg1 > Eg5 > Eg2, und wobei für die Gitterkonstante gilt a5 = a1 $\pm$ $\Delta$3 mit $\Delta$3 $\leq$ 0,01. Hierdurch weist die fünfte Teilzelle eine Bandlückenenergie zwischen der darüber liegenden ersten Teilzelle und der darunterliegenden zweiten Teilzelle auf. Der Solarzellenstapel weist in Folge fünf gestapelte Teilzellen auf.

In einer nicht beanspruchten Weiterbildung ist die Bandlückenenergie der Schicht der ersten Teilzelle größer als 1,88 eV und die Bandlückenenergie der Schicht der zweiten Teilzelle liegt zwischen 1,3 eV und 1,5 eV und die Bandlückenenergie der Schicht der dritten Teilzelle liegt zwischen 0,9 eV und 1,1 eV und die Bandlückenenergie der Schicht der vierten Teilzelle liegt zwischen 0,6 eV und 0,9 eV.

Auch ist es vorteilhaft, wenn die Schicht der ersten Teilzelle aus (Al)InGaP und die Schicht der zweiten Teilzelle aus InP und die Schicht der dritten Teilzelle aus InGaAsP und die Schicht der vierten Teilzelle aus InGaAs besteht. Untersuchungen haben gezeigt, dass eine derartige Kombination einen hohen Wirkungsgrad aufweist.

In einer anderen Weiterbildung ist die Bandlückenenergie der Schicht der ersten Teilzelle größer als 2,0 eV und die Bandlückenenergie der Schicht der zweiten Teilsolarelle liegt zwischen 1,2 eV und 1,4 eV und die Bandlückenenergie der Schicht der dritten Teilzelle liegt zwischen 0,9 eV und 1,1 eV und die Bandlückenenergie der Schicht der vierten Teilzelle liegt zwischen 0,6 eV und 0,9 eV und die Bandlückenenergie der Schicht der fünften Teilzelle liegt zwischen 1,4 eV und 1,7 eV.

Erfindungsgemäß besteht die Schicht der ersten Teilzelle aus AlInGaP und die Schicht der zweiten Teilzelle aus InP und die Schicht der dritten Teilzelle aus InGaAsP und die Schicht der vierten Teilzelle aus InGaAs und die Schicht der fünften Teilzelle aus Al(In)GaAs oder aus InGaAsP. In einer erfindungsgemäßen alternativen Ausführungsform besteht die Schicht der ersten Teilzelle aus AlInGaP und die Schicht der zweiten Teilzelle aus InGaAsP und die Schicht der dritten Teilzelle aus InGaAsP und die Schicht der vierten Teilzelle aus InGaAs und die Schicht der fünften Teilzelle aus Al(In)GaAs oder aus InGaAsP.

In einer nicht erfindungsgemäßen Weiterbildung ist der Wafer Bond zwischen der ersten Teilzelle und der zweiten Teilzelle ausgebildet, wobei für den Unterschied in den beiden Gitterkonstanten der beiden Teilzellen gilt a1 < a2 - 0,01 nm. Vorzugsweise beträgt der Unterschied zwischen den beiden Gitterkonstanten wenigstens 0,015 nm, höchst vorzugsweise wenigstens 0,03 nm.

Bevorzugt ist, dass die Schicht der zweiten Teilzelle und die Schicht der dritten Teilzelle zueinander gitterangepasst sind und dass für die Gitterkonstante gilt a2 = a3 $\pm$ $\Delta$1 oder dass gilt a2 = a3 $\pm$ $\Delta$2.

In einer bevorzugten Ausführungsform ist ein Superstrat mit der ersten Teilzelle stoffschlüssig verbunden und das Superstrat umfasst ein Deckglas. Unter dem Begriff Superstrat wird vorliegend ein Träger auf der Oberseite des Solarzellenstapels verstanden. In einer Weiterbildung erübrigt sich das Trägersubstrat unterhalb der Mehrfachsolarzelle wenigstens teilweise oder vollständig. Ein Vorteil ist, dass sich dadurch sehr leichte Solarzellen für Weltraumanwendungen herstellen lassen.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigt:

Figur 1    Ansicht auf eine nicht beanspruchteAusführungsformeine mit einer Vierfach Solarzelle,

Figur 2    eine detaillierte Ansicht auf die nicht beanspruchte Ausführungsform dargestellt in der Figur 1,

Figur 3    eine Ansicht auf eine nicht beanspruchte Ausführungsform mit einer Vierfach-Solarzelle mit einem optischen Spiegel,

Figur 4     eine Ansicht auf eine erfindungsgemäße Ausführungsform mit einer Fünffach-Solarzelle,

Figur 5     eine detaillierte Ansicht auf die Ausführungsform dargestellt in der Figur 4,

Figur 6     eine andere detaillierte Ansicht auf die Ausführungsform dargestellt in der Figur 4.

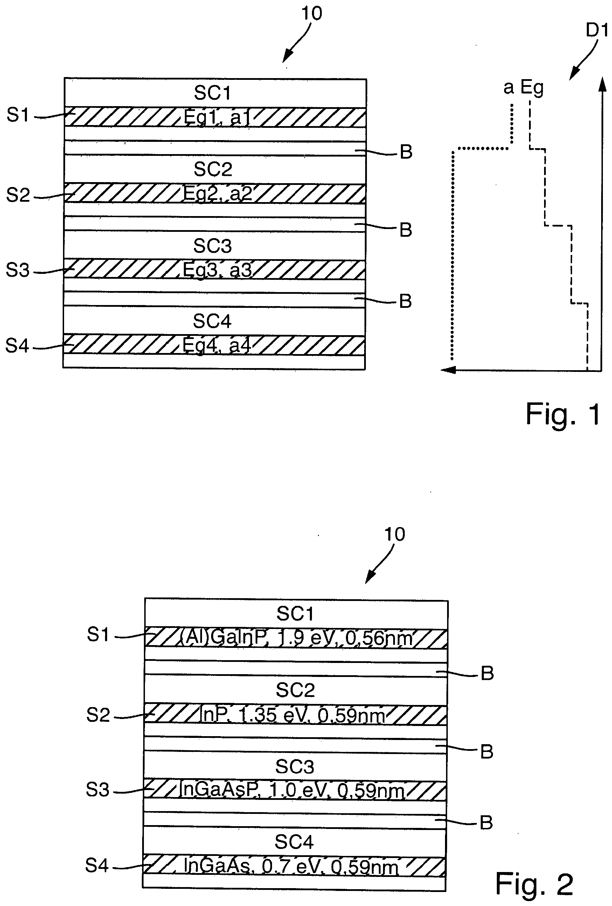

Die Figur 1 zeigt eine Ansicht einer nicht beanspruchten Ausführungsform einer stapelförmigen integrierten Mehrfachsolarzelle 10. In einem nebenstehenden Diagramm D1 ist der Verlauf der Gitterkonstante a und der Bandlücken Eg entlang des Stapels der Mehrfachsolarzelle 10 dargestellt.

Die Mehrfachsolarzelle 10 weist eine erste Teilzelle SC1 auf, wobei die erste Teilzelle SC1 eine Schicht S1 mit einer ersten Gitterkonstante a1 und einer ersten Bandlückenenergie Eg1 aufweist. Ferner weist die Mehrfachsolarzelle 10 eine zweite Teilzelle SC2 auf, wobei die zweite Teilzelle SC2 eine Schicht S2 mit einer zweiten Gitterkonstante a2 und einer zweiten Bandlückenenergie Eg2 aufweist. Auch weist die Mehrfachsolarzelle 10 eine dritte Teilzelle SC3 mit einer Schicht S3 mit einer dritten Gitterkonstanten a3 und einer dritten Bandlückenenergie Eg3 auf. Des Weiteren weist die Mehrfachsolarzelle 10 eine vierte Teilzelle SC4 auf, wobei die vierte Teilzelle SC4 eine Schicht S4 mit einer vierten Gitterkonstanten a4 und einer vierten Bandlückenenergie Eg4 aufweist. Wie in dem Diagramm D1 dargestellt ist zwischen den jeweiligen Schichten S1, S2, S3 und S4 und den zugehörigen Teilzellen SC1, SC2, SC3 und SC4 kein Unterschied in der Bandlückenenergie Eg und kein Unterschied in der Gitterkonstante a ausgebildet. Anders ausgedrückt sind die Teilzellen SC1, SC2, SC3 und SC4 hinsichtlich der beiden Parameter in sich homogen.

Zwischen zwei benachbarten Teilzellen SC1 und SC2 sowie SC2 und SC3 sowie SC3 und SC4 sind jeweils Verbindungsbereiche B ausgebildet. In den Verbindungsbereichen B sind jeweils eine Tunneldiode und weitere Schichten - jeweils nicht dargestellt - ausgebildet. Entsprechend der Darstellung in dem Diagramm D1 erfüllen die Bandlückenenergien Eg1, Eg2, Eg3 und Eg4 der einzelnen Teilzellen SC1, SC2, SC3 und SC4 und hierdurch auch die Schichten S1, S2, S3 und S4 in den einzelnen Teilzellen SC1, SC2, SC3 und SC4 die Beziehung Eg1 > Eg2 > Eg3 > Eg4.

Wie in dem Diagramm D1 dargestellt ist zwischen der ersten Teilzelle SC1 und der zweiten Teilzelle SC2 ein Wafer Bond mit einem Sprung in der Gitterkonstante a ausgebildet. Es sei angemerkt, dass der Sprung in der Gitterkonstante a eine Größe von mindestens 0,01 nm, vorzugsweise mindestens 0,015 nm und höchst vorzugsweise mindestens 0,03 nm umfasst. Anders ausgedrückt ist die Gitterkonstante a2 der zweiten Teilzelle SC2 um mindestens 0,01 nm größer als die Gitterkonstante a1 der ersten Teilzelle SC1 d.h. es gilt a1 < a2 - 0,01 nm. Vorzugsweise beträgt der Unterschied zwischen den beiden Gitterkonstanten a1 und a2 wenigstens 0,015 nm, höchst vorzugsweise wenigstens 0,03 nm. Es versteht sich, dass innerhalb des Verbindungsbereichs B die Dicke des Bereichs, in dem der Sprung ausgebildet ist, eine Dicke von maximal 200 nm, vorzugsweise maximal 100 nm und höchst vorzugsweise maximal 50 nm aufweist.

Außerdem ist die Schicht S2 der zweiten Teilzelle SC2 und die Schicht S3 der dritten Teilzelle SC3 und die Schicht S4 der vierten Teilzelle SC4 jeweils zueinander gitterangepasst. Für die Gitterkonstanten a2, a3 und a4 der Schichten S2, S3 und S4 der einzelnen Teilzellen SC2, SC3 und SC4 gilt, dass a2 = a3 ± Δ1 und a2 = a4 ± Δ1 mit Δ1 ≤ 0,003 nm ist, vorzugsweise gilt für die Gitterkonstanten, dass a2 = a3 ± Δ2 und a2 = a4 ± Δ2 mit, Δ2 = 0,0015 nm.

Ferner gilt für die Stöchiometrie der Schicht S2 der zweiten Teilzelle SC2 1 > m > 0,9 und 1 > n > 0,8 und für die Stöchiometrie der Schicht S3 der dritten Teilzelle SC3 1 > x > 0,2 und 1 > y > 0,1. Vorzugsweise gilt für die Stöchiometrie der Schicht S2 der zweiten Teilzelle SC2 m > 0,95 und n > 0,9 und/oder für die Stöchiometrie der Schicht S3 der dritten Teilzelle SC3 x > 0,65 und y > 0,3. Hierdurch weisen die Teilzellen SC2 und SC3 einen hohen Phosphorgehalt auf.

Ferner ist die Dicke der Schicht S1 der ersten Teilzelle SC1 größer als 100 nm, wobei die Schicht S1 als Teil des Emitters und / oder als Teil der Basis und / oder als Teil der zwischen Emitter und Basis liegenden Raumladungszone ausgebildet ist. Vorzugsweise umfasst die erste Teilzelle SC1 eine In-GaP Verbindung.

Des Weiteren ist die Dicke der Schicht S2 der zweiten Teilzelle SC2 größer als 100 nm, wobei die Schicht S2 als Teil des Emitters und / oder als Teil der Basis und / oder als Teil der zwischen Emitter und Basis liegenden Raumladungszone ausgebildet ist. Vorzugsweise umfasst die zweite Teilzelle SC2 eine $In_mP_n$ Verbindung.

Auch die Dicke der Schicht S3 der dritten Teilzelle SC3 ist größer als 100 nm, wobei die Schicht S3 als Teil des Emitters und / oder als Teil der Basis und / oder als Teil der zwischen Emitter und Basis liegenden Raumladungszone ausgebildet ist. Vorzugsweise umfasst die dritte Teilzelle SC3 eine $In_xGa_{1-x}As_{1-y}P_y$ Verbindung.

Ferner ist auch die Dicke der Schicht S4 der vierten Teilzelle SC4 größer als 100 nm, wobei die Schicht S4 als Teil des Emitters und / oder als Teil der Basis und / oder als Teil der zwischen Emitter und Basis liegenden Raumladungszone ausgebildet ist. Vorzugsweise umfasst die vierte Teilzelle SC4 eine InGaAs-Verbindung.

In der Abbildung der Figur 2 ist eine detaillierte Ansicht auf die nicht erfindungsgemäße Ausführungsform, dargestellt in der Figur 1, offenbart. Nachfolgend werden nur die Unterschiede zu den Erläuterungen in Zusammenhang mit der Darstellung in der Figur 1 angeführt.

Die Schicht S1 der ersten Teilzelle SC1 weist eine Gitterkonstante a1 von 0,56 nm auf und umfasst eine Verbindung aus (Al)GaInP mit einer Bandlückenenergie Eg1 von 1,9 eV. Ferner weist die Schicht S2 der zweiten Teilzelle SC2 eine Gitterkonstante a2 von 0,59 nm auf und umfasst eine Verbindung aus InP mit einer Bandlückenenergie Eg2 von 1,35 eV. Des Weiteren weist die Schicht S3 der dritten Teilzelle SC3 eine Gitterkonstante a3 von 0,59 nm auf und umfasst eine Verbindung aus InGaAsP mit einer Bandlückenenergie Eg3 von 1,0 eV. Schließlich weist die Schicht S4 der vierten Teilzelle SC4 eine Gitterkonstante a4 von 0,59 nm auf und umfasst eine Verbindung aus InGaAs mit einer Bandlückenenergie Eg4 von 0,7 eV.

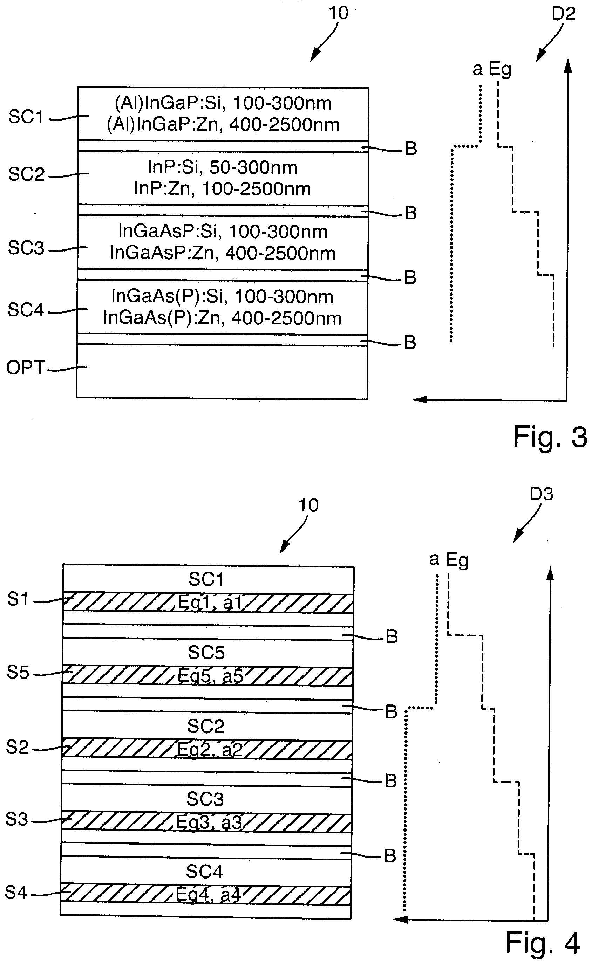

Die Abbildung der Figur 3 zeigt eine Ansicht auf eine nicht erfindungsgemäße Ausführungsform mit einer Vierfach-Solarzelle. Nachfolgend werden nur die Unterschiede zu den vorangegangenen Ausführungsformen angeführt.

In einem Diagramm D2 ist der Verlauf der Gitterkonstante a und der Verlauf der Bandlückenenergie Eg für die Teilzellen SC1 bis SC4 aufgetragen.

Die Schichten S1 bis S4 der ersten Teilzelle SC1 bis vierten Teilzelle SC4 sind mit den jeweiligen Teilzellen SC1 bis SC4 verschmolzen. Unterhalb der vierten Teilzelle SC4 ist ein optischer Spiegel bzw. Rückseitenspiegel OPT ausgebildet.

Die erste Teilzelle SC1 weist eine Gesamtdicke zwischen von 500 nm bis 2800 nm mit einer (Al)InGaP Verbindung auf. Vorzugsweise bestehen der Emitter und die Raumladungszone und die Basis der ersten Teilzelle SC1 vollständig aus der (Al)InGaP Verbindung. Die Gesamtdicke teilt sich in einen ersten n-dotierten Bereich mit einer Dicke von 100 nm bis 300 nm und einen p-dotierten Bereich mit einer Dicke von 400 nm bis 2500 nm auf. Der n-dotierte Bereich weist eine Si Dotierung, der p-dotierte Bereich eine Zn Dotierung auf.

Die zweite Teilzelle SC2 weist eine Gesamtdicke von 150 nm bis 2800 nm auf und umfasst eine InP Verbindung. Vorzugsweise bestehen der Emitter und die Raumladungszone und die Basis der zweiten Teilzelle SC2 vollständig aus der InP-Verbindung. Die Gesamtdicke teilt sich in einen ersten n-dotierten Bereich mit einer Dicke von 50 nm bis 300 nm und einen p-dotierten Bereich mit einer Dicke von 100 nm bis 2500 nm auf. Der n-dotierte Bereich weist eine Si Dotierung, der p-dotierte Bereich eine Zn Dotierung auf.

Die dritte Teilzelle SC3 weist eine Gesamtdicke von 1100 nm bis 2800 nm auf und umfasst eine InGaAsP Verbindung. Vorzugsweise bestehen der Emitter und die Raumladungszone und die Basis der dritten Teilzelle SC3 vollständig aus der InGaAsP Verbindung. Die Gesamtdicke teilt sich in einen ersten n-dotierten Bereich mit einer Dicke von 100 nm bis 300 nm und einen p-dotierten Bereich mit einer Dicke von 1000 nm -- 2500 nm auf. Der n-dotierte Bereich weist eine Si Dotierung, der p-dotierte Bereich eine Zn Dotierung auf.

Die vierte Teilzelle SC4 weist eine Gesamtdicke von 1100 nm bis 2800 nm auf und umfasst eine InGaAs Verbindung. Vorzugsweise bestehen der Emitter und die Raumladungszone und die Basis der vierten Teilzelle SC4 vollständig aus der InGaAs Verbindung. Die Gesamtdicke teilt sich in einen ersten n-dotierten Bereich mit einer Dicke von 100 nm bis 300 nm und einen p-dotierten Bereich mit einer Dicke von 1000 nm bis 2500 nm auf. Der n-dotierte Bereich weist eine Si Dotierung, der p-dotierte Bereich eine Zn Dotierung auf.

Die Abbildung der Figur 4 zeigt eine Ansicht auf eine erfindungsgemäße Ausführungsform mit einer Fünffach-Solarzelle. Nachfolgend werden nur die Unterschiede zu den vorangegangenen Ausführungsformen angeführt.

Zwischen der ersten Teilzelle SC1 und der zweiten Teilzelle SC2 ist eine fünfte Teilzelle SC5 mit einer Schicht S5 mit einer fünften Gitterkonstanten a5 und einer fünften Bandlückenenergie Eg5 ausgebildet. Die Dicke der Schicht S5 der fünften Teilzelle SC5 ist größer als 100 nm, wobei die Schicht S5 als Teil des Emitters und / oder als Teil der Basis und / oder als Teil der zwischen Emitter und Basis liegenden Raumladungszone ausgebildet ist.

In einem Diagramm D3 ist der Verlauf der Gitterkonstante a und der Verlauf der Bandlückenenergie Eg für die Teilzellen SC1 bis SC5 aufgetragen. Demnach ist in der vorliegenden Ausführungsform der Wafer Bond zwischen der fünften Teilzelle SC5 und der zweite Teilzelle SC2 ausgebildet. Ferner sind die erste Teilzelle SC1 und die fünfte Teilzelle SC5 zueinander gitterangepasst ausgebildet und weisen die gleiche Gitterkonstante a auf. Des Weiteren sind die zweite Teilzelle SC2 bis einschließlich der vierten Teilzelle SC4 ebenfalls jeweils zueinander gitterangepasst ausgebildet und weisen die gleiche Gitterkonstante a auf. Die Bandlückenenergie Eg5 der Schicht S5 der fünften Teilzelle SC5 ist größer als die Bandlückenenergie Eg2 der Schicht S2 der zweiten Teilzelle SC2 und kleiner als die Bandlückenenergie Eg1 der Schicht S1 der ersten Teilzelle SC1.

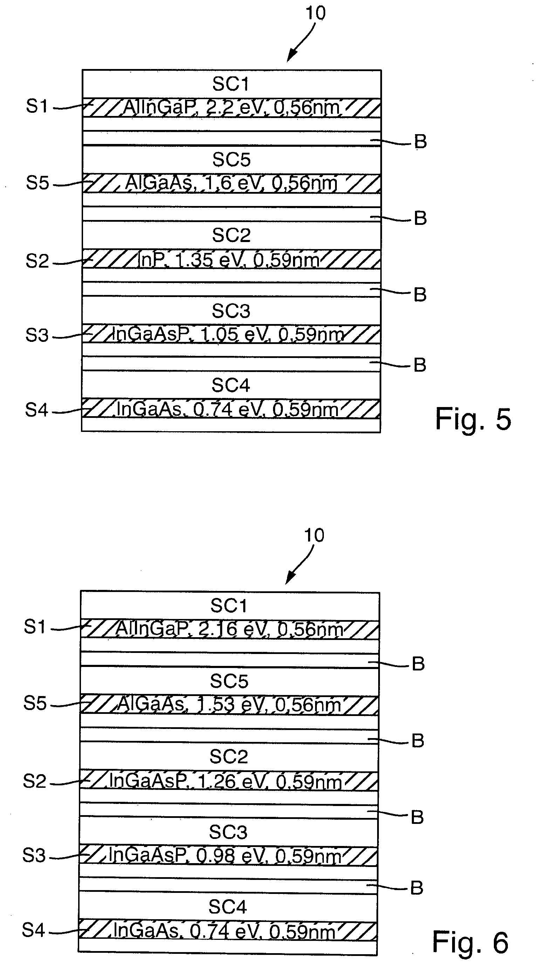

Die Abbildung der Figur 5 zeigt eine detailliertere Ansicht auf die erfindungsgemäße Ausführungsform mit der Fünffach-Solarzelle, dargestellt in Zusammenhang mit den Zeichnungsunterlagen der Figur 4. Nachfolgend werden nur die Unterschiede zu den vorangegangenen Ausführungsformen angeführt.

Die Schicht S1 der ersten Teilzelle SC1 weist eine Gitterkonstante a1 von 0,56 nm auf und umfasst eine Verbindung aus AlInGaP mit einer Bandlückenenergie Eg1 von 2,2 eV. Ferner weist die Schicht S5 der fünften Teilzelle SC5 eine Gitterkonstante a5 von 0,56 nm auf und umfasst eine Verbindung aus AlGaAs mit einer Bandlückenenergie Eg5 von 1,6 eV. Ferner weist die Schicht S2 der zweiten Teilzelle SC2 eine Gitterkonstante a2 von 0,59 nm auf und umfasst eine Verbindung aus InP mit einer Bandlückenenergie Eg2 von 1,35 eV. Des Weiteren weist die Schicht S3 der dritten Teilzelle SC3 eine Gitterkonstante a3 von 0,59 nm auf und umfasst eine Verbindung aus InGaAsP mit einer Bandlückenenergie Eg3 von 1,05 eV. Schließlich weist die Schicht S4 der vierten Teilzelle SC4 eine Gitterkonstante a4 von 0,59 nm auf und umfasst eine Verbindung aus InGaAs mit einer Bandlückenenergie Eg4 von 0,74 eV.

Die Abbildung der Figur 6 zeigt eine andere detailliertere Ansicht auf die erfindungsgemäße Ausführungsform mit der Fünffach-Solarzelle, dargestellt in Zusammenhang mit den Zeichnungsunterlagen der Figur 4. Nachfolgend werden nur die Unterschiede zu den vorangegangenen Ausführungsformen angeführt.

Die Schicht S1 der ersten Teilzelle SC1 weist eine Gitterkonstante a1 von 0,56 nm auf und umfasst eine Verbindung aus AlInGaP mit einer Bandlückenenergie Eg1 von 2,16 eV. Ferner weist die Schicht S5 der fünften Teilzelle SC5 eine Gitterkonstante a5 von 0,56 nm auf und umfasst eine Verbindung aus AlGaAs mit einer Bandlückenenergie Eg5 von 1,53 eV. Ferner weist die Schicht S2 der zweiten Teilzelle SC2 eine Gitterkonstante a2 von 0,59 nm auf und umfasst eine Verbindung aus InGaAsP mit einer Bandlückenenergie Eg2 von 1,26 eV. Des Weiteren weist die Schicht S3 der dritten Teilzelle SC3 eine Gitterkonstante a3 von 0,59 nm auf und umfasst eine Verbindung aus InGaAsP mit einer Bandlückenenergie Eg3 von 0,98 eV. Schließlich weist die Schicht S4 der vierten Teilzelle SC4 eine Gitterkonstante a4 von 0,59 nm auf und umfasst eine Verbindung aus InGaAs mit einer Bandlückenenergie Eg4 von 0,74 eV.

## Patentansprüche

1. Stapelförmige integrierte Mehrfachsolarzelle, mit

- einer ersten Teilzelle (SC1), wobei die erste Teilzelle (SC1) eine Schicht (S1) mit einer ersten Gitterkonstante (a1) und einer ersten Bandlückenenergie (Eg1) aufweist und die Schicht (S1) als Teil des Emitters und / oder als Teil der Basis und / oder als Teil der zwischen Emitter und Basis liegenden Raumladungszone ausgebildet ist,
- einer zweiten Teilzelle (SC2), wobei die zweite Teilzelle (SC2) eine Schicht (S2) mit einer zweiten Gitterkonstante (a2) und einer zweiten Bandlückenenergie (Eg2) aufweist und die Schicht (S2) als Teil des Emitters und / oder als Teil der Basis und / oder als Teil der zwischen Emitter und Basis liegenden Raumladungszone ausgebildet ist,
- einer dritten Teilzelle (SC3), wobei die dritte Teilzelle (SC3) eine Schicht (S3) mit einer dritten Gitterkonstanten (a3) und einer dritten Bandlückenenergie (Eg3) aufweist und die Schicht (S3) als Teil des Emitters und / oder als Teil der Basis und / oder als Teil der zwischen Emitter und Basis liegenden Raumladungszone ausgebildet ist,
- einer vierten Teilzelle (SC4), wobei die vierte Teilzelle (SC4) eine Schicht (S4) mit einer vierten Gitterkonstanten (a4) und einer vierten Bandlückenenergie (Eg4) aufweist und die Schicht (S4) als Teil des Emitters und / oder als Teil der Basis und / oder als Teil der zwischen Emitter und Basis liegenden Raumladungszone ausgebildet ist,
- für die Bandlückenenergien gilt Eg1 > Eg2 > Eg3 > Eg4 und
- zwischen zwei Teilzellen (SC1, SC2, SC3 und SC4) ein Bereich mit einem Wafer Bond ausgebildet ist, wobei
- der Bereich eine Dicke von maximal 200 nm aufweist, und die Gitterkonstante in dem Bereich einen Sprung von mindestens 0,01 nm macht,
- der Wafer Bond zwischen der ersten Teilzelle (SC1) und der zweiten Teilzelle (SC2) ausgebildet ist und die Schicht (S2) der zweiten Teilzelle (SC2) und die Schicht (S3) der dritten Teilzelle (SC3) und die Schicht S4 der vierten Teilzelle SC4 jeweils zueinander gitterangepasst sind und dass für die Gitterkonstanten a2, a3 und a4 der Schichten S2, S3 und S4 der einzelnen Teilzellen SC2, SC3 und SC4 gilt a2 = a3 $\pm$ $\Delta$1, a2 = a4 $\pm$ $\Delta$1 und a3 = a4 $\pm$ $\Delta$1 mit $\Delta$1 $\leq$ 0,003 nm,
- die Schicht (S1) der ersten Teilzelle (SC1) aus AlInGaP besteht,
- die Schicht (S2) der zweiten Teilzelle (SC2) aus InP oder aus InGaAsP besteht,
- die Schicht (S3) der dritten Teilzelle (SC3) aus $In_xGa_{1-x}As_{1-y}P_y$ besteht, und für die Stöchiometrie der Schicht (S3) der dritten Teilzelle (SC3) gilt 1 > x > 0,2 und 1 > y > 0,1 und
- die Schicht (S4) der vierten Teilzelle (SC4) aus InGaAs besteht,
- die Dicke der Schicht (S1) der ersten Teilzelle (SC1) und der Schicht (S2) der zweiten Teilzelle (SC2) und der Schicht (S3) der dritten Teilzelle (SC3) und der Schicht (S4) der vierten Teilzelle (SC4) jeweils größer als 100 nm ist,
- zwischen der ersten Teilzelle (SC1) und dem Wafer Bond eine fünfte Teilzelle (SC5) ausgebildet ist, wobei die fünfte Teilzelle (SC5) eine Schicht (S5) mit einer fünften Gitterkonstanten (a5) und einer fünften Bandlückenenergie (Eg5) aufweist, und die Dicke der Schicht (S5) grö-ßer als 100 nm ist und die Schicht (S5) als Teil des Emitters und / oder als Teil der Basis und / oder als Teil der zwischen Emitter und Basis liegenden Raumladungszone ausgebildet ist, und wobei gilt Eg1 > Eg5 > Eg2, und wobei für die Gitterkonstante gilt a5 = a1 $\pm$ $\Delta$3 mit $\Delta$3 $\leq$ 0,01,
- die Schicht der fünften Teilzelle aus Al(In)GaAs oder aus InGaAsP besteht.

2. Mehrfachsolarzelle nach einem der vorangehenden Ansprüche, **dadurch gekennzeichnet, dass** der

**EP 3 012 874 B1**

Bereich in dem der Sprung ausgebildet ist, eine Dicke von maximal 100 nm aufweist, und/oder die Gitterkonstante in dem Bereich einen Sprung von mindestens 0,015 nm macht.

3. Mehrfachsolarzelle nach Anspruch 1, **dadurch gekennzeichnet, dass** die Bandlückenenergie (Eg1) der Schicht (S1) der ersten Teilzelle (SC1) größer 2,0 eV ist und die Bandlückenenergie (Eg2) der Schicht (S2) der zweiten Teilsolarelle (SC2) zwischen 1,2 eV und 1,4 eV liegt und die Bandlückenenergie (Eg3) der Schicht (S3) der dritten Teilzelle (SC3) zwischen 0,9 eV und 1,1 eV liegt und die Bandlückenenergie (Eg4) der Schicht (S4) der vierten Teilzelle (SC4) zwischen 0,6 eV und 0,9 eV liegt und die Bandlückenenergie (Eg5) der Schicht (S5) der fünften Teilzelle (SC5) zwischen 1,4 eV und 1,7 eV liegt.

4. Mehrfachsolarzelle nach einem der vorangehenden Ansprüche, **dadurch gekennzeichnet, dass** ein Superstrat mit der ersten Teilzelle (SC1) stoffschlüssig verbunden ist und das Superstrat ein Deckglas umfasst.

5. Mehrfachsolarzelle nach einem der vorangehenden Ansprüche, **dadurch gekennzeichnet, dass** ein Halbleiterspiegel zwischen der dritten Teilzelle und vierten Teilzelle ausgebildet ist und / oder ein optischer Spiegel (OPT) unterhalb der vierten Teilzelle ausgebildet ist.

**Claims**

1. Integrated stacked multiple solar cell, comprising

    - a first part cell (SC1), wherein the first part cell (SC1) has a layer (S1) with a first lattice constant (a1) and a first band gap energy (Eg1) and the layer (S1) is constructed as part of the emitter and/or as part of the base and/or as part of the spatial charge zone lying between emitter and base,
    - a second part cell (SC2), wherein the second part cell (SC2) has a layer (S2) with a second lattice constant (a2) and a second band gap energy (Eg2) and the layer (S2) is constructed as part of the emitter and/or as part of the base and/or as part of the spatial charge zone lying between emitter and base,
    - a third part cell (SC3), wherein the third part cell (SC3) has a layer (S3) with a third lattice constant (a3) and a third band gap energy (Eg3) and the layer (S3) is constructed as part of the emitter and/or as part of the base and/or as part of the spatial charge zone lying between emitter and base,

    - a fourth part cell (SC4), wherein the fourth part cell (SC4) has a layer (S4) with a fourth lattice constant (a4) and a fourth band gap energy (Eg4) and the layer (S4) is constructed as part of the emitter and/or as part of the base and/or as part of the spatial charge zone lying between emitter and base,
    - Eg1 > Eg2 > Eg3 > Eg4 for the band gap energies and
    - a region with a wafer bond is formed between two part cells (SC1, SC2, SC3 and SC4), wherein
    - the region has a thickness of at most 200 nm and the lattice constant in the region makes a jump of at least 0.01 nm,
    - the wafer bond is formed between the first part cell (SC1) and the second part cell (SC2) and the layer (S2) of the second part cell (SC2) and the layer (S3) of the third part cell (SC3) and the layer (S4) of the fourth part cell (SC4) are respectively lattice-matched to one another and for the lattice constants (a2, a3 and a4) of the layers (S2, S3 and S4) of the individual part cells (SC2, SC3 and SC4)
    $a2 = a3 \pm \Delta1$, $a2 = a4 \pm \Delta1$ and $a3 = a4 \pm \Delta1$, wherein $\Delta1 \leq 0.003$ nm,
    - the layer (S1) of the first part cell (SC1) consists of AlInGaP,
    - the layer (S2) of the second part cell (SC2) consists of InP or of InGaAsP,
    - the layer (S3) of the third part cell (SC3) consists of $In_xGa_{1-x}As_{1-y}P_y$ and for the stoichiometry of the layer (S3) of the third part cell (SC3) $1 > x > 0.2$ and $1 > y > 0.1$ and
    - the layer (S4) of the fourth part cell (SC4) consists of InGaAs,
    - the thickness of the layer (S1) of the first part cell (SC1) and of the layer (S2) of the second part cell (SC2) and of the layer (S3) of the third part cell (SC3) and of the layer (S4) of the fourth part cell (SC4) is greater each time than 100 nm,
    - a fifth part cell (SC5) is constructed between the first part cell (SC1) and the wafer bond, wherein the fifth part cell (SC5) has a layer (S5) with a fifth lattice constant (a5) and a fifth band gap energy (Eg5) and the thickness of the layer (S5) is greater than 100 nm and the layer (S5) is constructed as part of the emitter and/or as part of the base and/or as part of the spatial charge zone lying between emitter and base, and wherein

    $$Eg1 > Eg5 > Eg2$$

    and wherein for the lattice constant
    $a5 = a1 \pm \Delta3$, wherein $\Delta3 \leq 0.01$,
    - the layer of the fifth part cell consists of Al(In)GaAS or of InGaAsP.

2. Multiple solar cell according to the preceding claim, **characterised in that** the region in which the jump is formed has a thickness of at most 100 nm and/or the lattice constant in the region makes a jump of at least 0.015 nm.

3. Multiple solar cell according to claim 1, **characterised in that** the band gap energy (Eg1) of the layer (S1) of the first part cell (SC1) is greater than 2.0 eV and the band gap energy (Eg2) of the layer (S2) of the second part solar cell (SC2) lies between 1.2 eV and 1.4 eV and the band gap energy (Eg3) of the layer (S3) of the third part cell (SC3) lies between 0.9 eV and 1.1 eV and the band gap energy (Eg4) of the layer (S4) of the fourth part cell (SC4) lies between 0.6 eV and 0.9 eV and the band gap energy (Eg5) of the layer (S5) of the fifth part cell (SC5) lies between 1.4 eV and 1.7 eV.

4. Multiple solar cell according to any one of the preceding claims, **characterised in that** a superstrate is connected by material couple with the first part cell (SC1) and the superstrate comprises a cover glass.

5. Multiple solar cell according to any one of the preceding claims, **characterised in that** a semiconductor mirror is constructed between the third part cell and fourth part cell and/or an optical mirror (OPT) is constructed below the four part cell.

**Revendications**

1. Cellule solaire à jonctions multiples intégrée en forme de pile comprenant

- une première sous-cellule (SC1), laquelle première sous-cellule (SC1) comporte une couche (S1) avec une première constante de réseau (a1) et une première énergie de bande interdite (Eg1) et la couche (S1) est configurée comme une partie de l'émetteur et/ou comme une partie de la base et/ou comme une partie de la zone de charge d'espace située entre l'émetteur et la base,
- une deuxième sous-cellule (SC2), laquelle deuxième sous-cellule (SC2) comporte une couche (S2) avec une deuxième constante de réseau (a2) et une deuxième énergie de bande interdite (Eg2) et la couche (S2) est configurée comme une partie de l'émetteur et/ou comme une partie de la base et/ou comme une partie de la zone de charge d'espace située entre l'émetteur et la base,
- une troisième sous-cellule (SC3), laquelle troisième sous-cellule (SC3) comporte une couche (S3) avec une troisième constante de réseau (a3) et une troisième énergie de bande interdite (Eg3) et la couche (S3) est configurée comme une partie de l'émetteur et/ou comme une partie de la base et/ou comme une partie de la zone de charge d'espace située entre l'émetteur et la base,
- une quatrième sous-cellule (SC4), laquelle quatrième sous-cellule (SC4) comporte une couche (S4) avec une quatrième constante de réseau (a4) et une quatrième énergie de bande interdite (Eg4) et la couche (S4) est configurée comme une partie de l'émetteur et/ou comme une partie de la base et/ou comme une partie de la zone de charge d'espace située entre l'émetteur et la base,
- les énergies de bande interdite étant telles que Eg1 > Eg2 > Eg3 > Eg4 et
- une zone avec un collage de plaquettes étant formée entre deux sous-cellules (SC1, SC2, SC3 et SC4), dans laquelle
- cette zone présente une épaisseur de 200 nm maximum et la constante de réseau dans la zone fait un saut d'au moins 0,01 nm,
- le collage de plaquettes est créé entre la première sous-cellule (SC1) et la deuxième sous-cellule (SC2) et la couche (S2) de la deuxième sous-cellule (SC2) et la couche (S3) de la troisième sous-cellule (SC3) et la couche (S4) de la quatrième sous-cellule (SC4) sont appariées réticulairement entre elles, les constantes de réseau a2, a3 et a4 des couches S2, S3 et S4 des sous-cellules SC2, SC3 et SC4 étant telles que a2 = a3 $\pm$ $\Delta$1, a2 = a4 $\pm$ $\Delta$1 et a3 = a4 $\pm$ $\Delta$1 avec $\Delta$1 $\leq$ 0,003 nm,
- la couche (S1) de la première sous-cellule (SC1) est constituée d'AlInGaP,
- la couche (S2) de la deuxième sous-cellule (SC3) est constituée d'InP ou d'InGaAsP,
- la couche (S3) de la troisième sous-cellule (SC3) est constituée d'$In_xGa_{1-x}As_{1-y}P_y$ et la stoechiométrie de la couche (S3) de la troisième sous-cellule (SC3) est telle que 1 > x > 0,2 et 1 > y > 0,1 et
- la couche (S4) de la quatrième sous-cellule (SC4) est constituée d'InGaAs,
- l'épaisseur de la couche (S1) de la première sous-cellule (SC1) et l'épaisseur de la couche (S2) de la deuxième sous-cellule (SC2) l'épaisseur de la couche (S3) de la troisième sous-cellule (SC3) l'épaisseur de la couche (S4) de la quatrième sous-cellule (SC4) est respectivement supérieure à 100 nm,
entre la première sous-cellule (SC1) et le collage de plaquettes est formée une cinquième sous-cellule (SC5), laquelle cinquième sous-cellule (SC5) comporte une couche (S5) avec une cinquième constante de réseau (a5) et une cinquième énergie de bande interdite (Eg5), et l'épaisseur de la couche (S5) est supérieure à 100 nm et la couche (S5) est configurée comme une partie de l'émetteur et/ou comme une partie de la base et/ou comme une partie de la zone de charge d'espace située entre l'émetteur et la base, et dans laquelle Eg1 > Eg5 > Eg2 et la constante de réseau est telle que a5 = a1 $\pm$ $\Delta$3 avec $\Delta$3 $\leq$ 0,01, et
- la couche de la cinquième sous-cellule est constituée d'Al(In)GaAs ou d'InGaAsP.

2. Cellule solaire à jonctions multiples selon une des revendications précédentes, **caractérisée en ce que** la zone dans laquelle le saut est formé présente une épaisseur de 100 nm maximum et/ou la constante de réseau dans la zone fait un saut d'au moins 0,015 nm.

3. Cellule solaire à jonctions multiples selon la revendication 1, **caractérisée en ce que** l'énergie de bande interdite (Eg1) de la couche (S1) de la première sous-cellule (SC1) est supérieure à 2,0 eV et l'énergie de bande interdite (Eg2) de la couche (S2) de la deuxième sous-cellule (SC2) est située entre 1,2 et 1,4 eV et l'énergie de bande interdite (Eg3) de la couche (S3) de la troisième sous-cellule (SC3) est située entre 0,9 eV et 1,1 eV et l'énergie de bande interdite (Eg4) de la couche (S4) de la quatrième sous-cellule (SC4) est située entre 0,6 eV et 0,9 eV et l'énergie de bande interdite (Eg5) la couche (S5) de la cinquième sous-cellule (SC5) est située entre 1,4 eV et 1,7 eV.

4. Cellule solaire à jonctions multiples selon une des revendications précédentes, **caractérisée en ce qu'**une strate supérieure est reliée par conjugaison de matière avec la première sous-cellule (SC1) et que cette strate supérieure comprend un verre de protection.

5. Cellule solaire à jonctions multiples selon une des revendications précédentes, **caractérisée en ce qu'**un miroir à semi-conducteur est formé entre la troisième sous-cellule et la quatrième sous-cellule et/ou qu'un miroir optique (OPT) est formé au-dessous de la quatrième sous-cellule.

Fig. 1

Fig. 2

Fig. 3

Fig. 4

Fig. 5

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20120138116 A1
- US 20090229659 A1
- US 20060185582 A1
- DE 102012004734 A1

**In der Beschreibung aufgeführte Nicht-Patentliteratur**

- **W. GUTER.** Optimierung von III-V basierten Hochleistungssolarzellen. Uni Konstanz, Fakultät für Physik, 2011
- **MEUSEL et al.** *III-V MULTIJUNCTION SOLAR CELLS - FROM CURRENT SPACE AND TERRESTRIAL PRODUCTS TO MODERN CELL ARCHITECTURES, 5th WCPEC,* 2010
- **GUTER et al.** DEVELOPMENT, QUALIFICATION AND PRODUCTION OF SPACE SOLAR CELLS WITH 30% EOL EFFICIENCY. *European Space Power Conference,* 2014
- **CORNFELD et al.** Development of a four sub-cell inverted metamorphic multi-junction (IMM) highly efficient AM0 solar cell. *35th IEEE PVSC,* 2010
- **UWE SEIDEL.** Grenzflächenuntersuchungen am Tunnelkontakt einer MOCVD-präparierten Tandemsolarzelle. Mathematisch-Naturwissenschaftlichen Fakultät, 09. Januar 2007
- **J. BOISVERT et al.** Development of advanced space solar cells at spectrolab. *Photovoltaic Specialists Conference (PVSC), 2010 35th IEEE,* 20. Juni 2010, ISSN 0160-8371
- **R. KRAUSE et al.** Wafer Bonded 4-Junction GaInP/GaAs//GaInAsP/GaInAs. *AIP Conference Proceedings,* 2014, vol. 1616, 45
- **P.T. CHIU et al.** Direct Semiconductor Bonded 5J Cell For Space And Terrestrial Applications. *IEEE Journal of Photovoltaics,* 2014, vol. 4 (1), 493
- **T. SHARPS et al.** Development of 20% efficient GaIn-AsP solar cells. *Proceedings of the Photovoltaic Specialists Conference,* 1993, ISBN 978-0-7803-1220-3, 633-638
- **BISSELS.** Optimum Bandgap Calculations for a 4-Terminal Double Tandem III-V Concentrator Solar Cell Structure. *Proceedings of the 22nd photovoltaic solar energy conference,* 03. September 2007, ISBN 978-3-936 338-22-5